# DEMANDE DE BREVET EUROPEEN

(11) **EP 0 913 858 A1**
(43) Date de publication de la demande: **06.05.1999**
(21) Numéro de dépôt: 98410127.9
(22) Date de dépôt: 30.10.1998
(51) Int. Cl.: H01L 21/304

(54) **Procédé d'amincissement d'une plaquette de semiconducteur**

(30) Priorité: 31.10.1997 FR 9713986
(71) Demandeur: STMicroelectronics SA, 94250 Gentilly Cedex (FR)
(72) Inventeur: Vandeputte, Jacques, 37390 Charentilly (FR)
(74) Mandataire: de Beaumont, Michel

(57) **Abrégé**

L'invention concerne un procédé d'amincissement d'une plaquette de semiconducteur (2) par rectification d'une face arrière (21), et comporte une étape de dressage du bord (22) de la plaquette, de façon à obtenir un bord droit (22') sensiblement sur toute l'épaisseur de la plaquette.

## Description

La présente invention concerne de façon générale la fabrication de composants semiconducteurs et plus particulièrement l'amincissement d'une plaquette de semiconducteur par rectification de sa face arrière.

Dans des procédés usuels de fabrication de circuits intégrés, éventuellement après divers autres traitements (implantation/diffusion, dépôt ou croissance d'isolant) de la plaquette, on est amené à rectifier la face arrière de cette plaquette. Par exemple, on peut souhaiter ramener, par rectification, une plaquette d'un diamètre de 200 mm, présentant une épaisseur initiale de l'ordre de 800 µm à une épaisseur finale d'environ 150 à 200 µm.

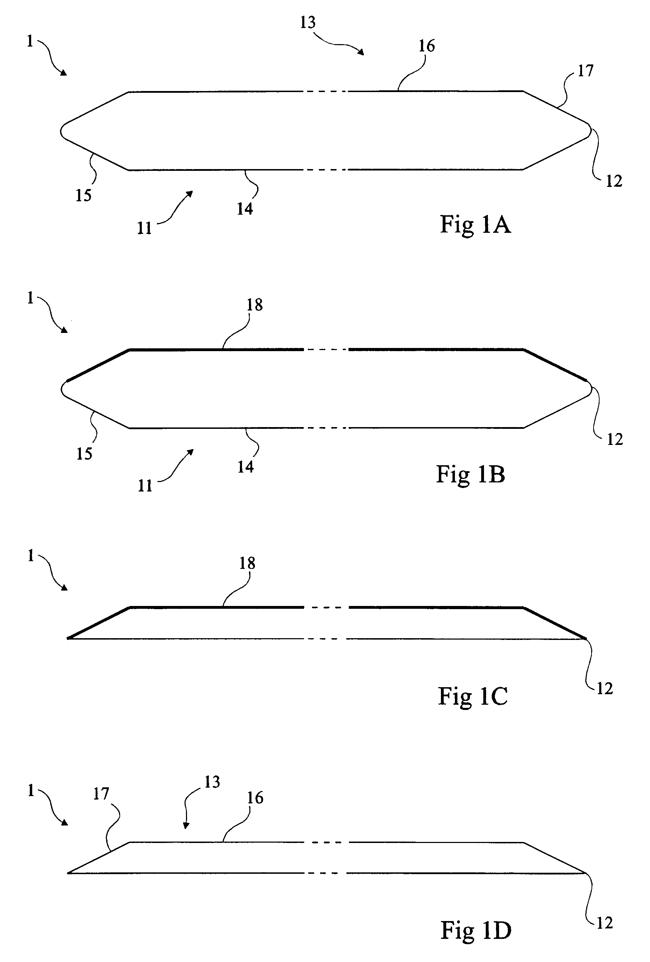

Les figures 1A à 1D illustrent un exemple classique d'un procédé de rectification par meulage d'une face arrière d'une plaquette.

Une plaquette 1 comporte typiquement (figure 1A) une face arrière 11 devant être rectifiée, un bord arrondi 12, de très petite dimension par rapport à l'épaisseur totale de la plaquette, et une face avant 13. La face avant 13, depuis laquelle ont été formés les circuits intégrés, ne doit pas être rectifiée. Chacune des faces arrière 11 et avant 13 comprend une surface principale plane, respectivement 14, 16, et une portion périphérique inclinée, respectivement 15, 17, entre sa surface et le bord 12. Le profil de la plaquette est donc sensiblement en biseau (dit "en forme de bec"). Ce profil est choisi, en particulier, pour permettre d'obtenir une couche épitaxiée, parfaitement homogène et plane sur la surface 16 de la plaquette.

La face avant 13 est généralement recouverte d'une protection 18 (figure 1B) pour protéger les circuits intégrés contre les poussières et/ou éclats issus du meulage de l'étape ultérieure. Cette protection est, par exemple, constituée d'une couche de résine rapportée sur la face avant et d'une feuille de protection collée sur la résine. La résine forme une interface entre les circuits intégrés et la feuille de protection, et constitue une couche d'enlèvement de la feuille de protection en fin de procédé.

Après rectification par meulage de la face arrière 11, on obtient une plaquette amincie (figure 1C) ayant l'épaisseur finale souhaitée.

Enfin, la feuille de protection 18 est retirée par dissolution de la résine et on obtient la forme définitive de la plaquette (figure 1D). La face avant 13 n'ayant pas été modifiée, elle comporte toujours des surfaces plane 16 et inclinée 17. Le profil de la plaquette amincie est donc sensiblement en lame de rasoir.

L'inconvénient majeur de ce type de procédé réside dans cette forme en lame de rasoir obtenue en fin de rectification. En effet, un tel profil est particulièrement fragile et sensible aux chocs, en raison de la très faible épaisseur périphérique. Ces chocs provoquent des fêlures ou fissures, voire même des éclats et/ou cassures, dans la structure de la plaquette et conduisent à un fort pourcentage de pertes. De tels chocs sont hélas inévitables pendant des traitements ultérieurs (retrait de la protection, placement de la plaquette dans un boîtier de rangement, découpe des puces, etc.).

La présente invention vise à pallier cet inconvénient. Plus particulièrement, un objet de la présente invention est de proposer un nouveau procédé de rectification qui minimise les risques d'endommagement de la plaquette, liés à la fragilité excessive de ses bords.

Pour atteindre cet objet, la présente invention prévoit un procédé d' amincissement d'une plaquette de semiconducteur par rectification d'une face arrière, comportant une étape de dressage du bord de la plaquette, de façon à obtenir un bord droit sensiblement sur toute l'épaisseur de la plaquette.

Selon un mode de réalisation de la présente invention, une face avant de la plaquette est recouverte d'un moyen de protection, ce moyen de protection étant de même forme et de dimensions plus petites que la plaquette, le dressage du bord s'effectuant hors du moyen de protection.

Selon un mode de réalisation de la présente invention, on forme au moins un chanfrein ou arrondi entre le bord droit de la plaquette et sa face avant.

Selon un mode de réalisation de la présente invention, le chanfrein est formé pendant le dressage du bord.

Ces objets, caractéristiques et avantages, ainsi que d'autres de la présente invention seront exposés en détail dans la description suivante de modes de mise en oeuvre particuliers faite à titre non-limitatif en relation avec les figures jointes parmi lesquelles :
les figures 1A à 1D décrites précédemment sont destinées à exposer l'état de la technique et le problème posé ;
les figures 2A à 2D représentent, vue en coupe et très schématiquement, une plaquette de semiconducteur à différentes étapes d'un premier mode de mise en oeuvre d'un procédé d'amincissement selon la présente invention ;
la figure 3 représente, partiellement et en coupe, une plaquette de semiconducteur selon une variante du procédé selon la présente invention ; et
la figure 4 illustre, partiellement et vue en coupe, un mode de mise en oeuvre d'une étape de dressage de bord du procédé selon la présente invention.

Pour des raisons de clarté, les représentations des différentes figures ne sont pas à l'échelle.

Une caractéristique de la présente invention est de prévoir une étape de dressage de bord de la plaquette de semiconducteur, c'est-à-dire de rectification périphérique, perpendiculairement à la plaquette, de préférence avant la rectification de sa face arrière.

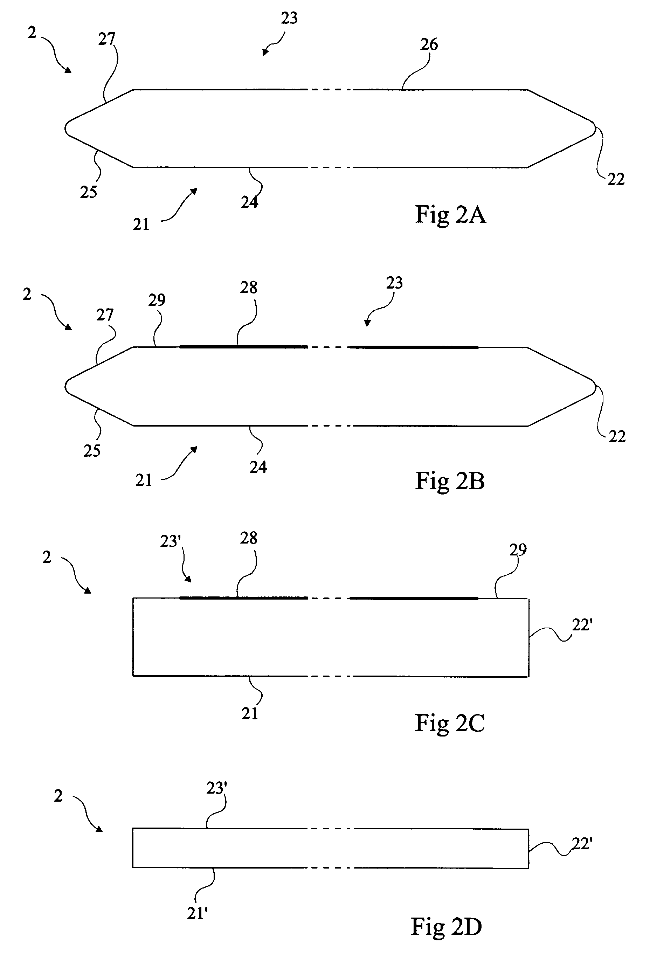

Les figures 2A à 2D illustrent un premier mode de mise en oeuvre du procédé selon la présente invention.

La figure 2A représente une plaquette de semiconducteur 2 avant amincissement (identique à la plaquette 1 en figure 1A) constituée d'une face arrière 21 (à rectifier), d'un bord 22, de très petite dimension comparée à l'épaisseur totale de la plaquette, et d'une face avant 23. Les faces arrière 21 et avant 23 comportent, comme précédemment, des surfaces planes 24, 26, et inclinées 25, 27. Des circuits intégrés (non représentés) sont formés dans la face avant 23.

Dans un premier temps, comme dans un procédé classique, on cherche à protéger la face avant 23 des débris de meulage.

Pour ce faire et selon le mode de mise en oeuvre représenté à la figure 2B, on utilise une protection 28 de même constitution (résine et feuille) que dans un procédé classique. Cependant, la feuille de protection selon l'invention présente un diamètre inférieur à celui de la plaquette 2 de façon à s'arrêter avant la surface inclinée 27. En d'autres termes, la feuille de protection est placée uniquement sur une partie de la surface plane 26 (figure 2A) de la face avant 23, laissant la périphérie 29 de cette surface plane 26 ainsi que la surface inclinée 27 totalement découvertes.

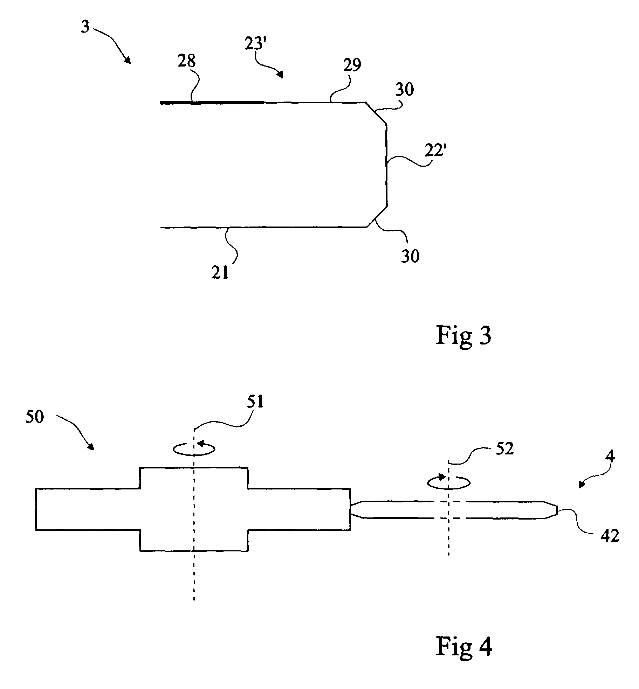

La plaquette 2 subit alors un dressage de bord qui sera détaillé en relation avec la figure 4, pour conduire au profil à angles droits représenté en figure 2C. La plaquette 2 comporte alors un bord droit 22' sur toute son épaisseur. Les surfaces inclinées (25, 27 figures 2A et 2B) ayant été supprimées, les faces arrière 21 et avant 23' sont sensiblement planes et de dimensions inférieures à celles d'origine. En considérant plus particulièrement la face avant 23', la protection 28 est intacte.

On effectue alors l'étape classique de meulage de la face arrière puis on enlève la protection 28 et on obtient (figure 2D) une plaquette amincie dont les deux faces 21' et 23' sont dépourvues de surfaces inclinées et présentent un diamètre légèrement réduit, le bord de la plaquette étant à angles droits.

A titre de variante, on pourra utiliser une protection rigoureusement identique à une protection classique (18, figure 1B) de même diamètre que la plaquette. Toutefois, une telle solution ne constitue pas un mode de mise en oeuvre préféré car il est alors nécessaire d'attaquer, lors du dressage de bord, plusieurs matériaux (la plaquette, la feuille de protection et la couche de résine) présentant des caractéristiques mécaniques différentes. Cela présente un risque de détérioration de la protection, par soulèvement, déchirement ou entraînement.

Selon une autre variante, on pourra effectuer le dressage de bord après la rectification de la face arrière. Toutefois, effectuer le dressage de bord avant rectification présente l'avantage majeur de travailler sur une plaquette moins fragile.

Selon une autre variante, on pourra en outre réaliser un chanfrein ou un arrondi sur l'une ou les deux faces de la plaquette afin d' optimiser la résistance mécanique du bord de la plaquette. Ceci est décrit en relation avec la figure 3 qui représente partiellement et en coupe une plaquette 3.

De préférence, la meule utilisée pour dresser le bord de la plaquette et fournir le résultat illustré en figure 2C est modifiée pour former des chanfreins ou arrondis 30 illustrés en figure 3, dans laquelle on a utilisé par ailleurs les mêmes références qu'en figure 2C.

La face arrière 31 de la plaquette est ensuite meulée conformément au procédé décrit en relation avec la figure 2D.

A titre de variante, on pourra former le chanfrein ou arrondi 30 après la rectification de la face arrière. Toutefois, former le chanfrein avant rectification présente l'avantage majeur de travailler sur une plaquette moins fragile.

Un dispositif préféré de mise en oeuvre de l'étape de dressage de bord est décrit en relation avec la figure 4.

Le dispositif comporte essentiellement une meule horizontale 50 mise en rotation autour d'un axe vertical 51. Une plaquette 4, dont le bord 42 doit être dressé, a été préparée conformément aux étapes décrites en relation avec les figures 2A et 2B. La plaquette 4 est amenée latéralement, de sorte que son bord droit 42 soit maintenu en contact avec la meule jusqu'à atteindre le profil à angles droits voulu (figures 2C, 3A).

La plaquette 4 est également entraînée en rotation autour d'un axe vertical 52, par exemple en étant portée par un plateau rotatif (non représenté), en sens contraire par rapport à la meule 50 et, de préférence, à une vitesse inférieure à la vitesse de rotation de la meule.

Un avantage de la présente invention est qu'elle rend la plaquette beaucoup moins fragile pour les traitements et manipulations ultérieurs.

Un autre avantage de la présente invention est de réduire considérablement le taux de perte de circuits intégrés par détérioration mécanique de la plaquette.

Un avantage supplémentaire de la présente invention est qu'elle ne nécessite aucune modification des étapes de meulage de la face arrière proprement dites.

Bien entendu, la présente invention est susceptible de diverses variantes et modifications qui apparaîtront à l'homme de l'art. En particulier, le dressage de bord peut être effectué par toute technique adaptée.

## Revendications

1. Procédé d'amincissement d'une plaquette de semiconducteur (2, 3, 4) par rectification d'une face arrière (21), caractérisé en ce qu'il comporte une étape de dressage du bord (22, 42) de la plaquette, de façon à obtenir un bord droit (22') sensiblement sur toute l'épaisseur de la plaquette.

2. Procédé selon la revendication 1, dans lequel une face avant (23, 23') de la plaquette (2, 3, 4) est recouverte d'un moyen de protection (28, 38), caractérisé en ce que le moyen de protection est de même forme et de dimensions plus petites que la plaquette, le dressage du bord (22, 42) s'effectuant hors du moyen de protection.

3. Procédé selon la revendication 2, caractérisé en ce qu'il consiste à former au moins un chanfrein ou arrondi (30) entre le bord droit (22') de la plaquette (2, 3, 4) et sa face avant (23').

4. Procédé selon la revendication 3, caractérisé en ce que le chanfrein (30) est formé pendant le dressage du bord.
